(19) **Europäisches Patentamt**
**European Patent Office**
**Office européen des brevets**

(11) **EP 2 707 737 B1**

(12) **FASCICULE DE BREVET EUROPEEN**

(45) Date de publication et mention
de la délivrance du brevet:
**05.12.2018 Bulletin 2018/49**

(51) Int Cl.:
***G01R 31/36*** *(2006.01)*

(21) Numéro de dépôt: **12720241.4**

(86) Numéro de dépôt international:
**PCT/FR2012/050734**

(22) Date de dépôt: **05.04.2012**

(87) Numéro de publication internationale:
**WO 2012/156603 (22.11.2012 Gazette 2012/47)**

(54) **PROCEDE D'ESTIMATION DE L'ETAT DE FONCTIONNEMENT D'UNE BATTERIE POUR UN SYSTEME D'ARRET/RELANCE AUTOMATIQUE DU MOTEUR THERMIQUE D'UN VEHICULE, CAPTEUR ET SYSTEME DE GESTION DE BATTERIE ADAPTES**

VERFAHREN ZUR SCHÄTZUNG DES FUNKTIONSZUSTANDES EINER BATTERIE FÜR EIN AUTOMATISCHES STOPP/START-SYSTEM EINER WÄRMEKRAFTMASCHINE IN EINEM FAHRZEUG SOWIE ADAPTIERTES BATTERIEVERWALTUNGSSYSTEM UND SENSOR

METHOD FOR ESTIMATING THE STATE-OF-FUNCTION OF A BATTERY FOR A AN AUTOMATIC STOP/RESTART SYSTEM OF THE HEAT ENGINE OF A VEHICLE, AND ADAPTED BATTERY MANAGEMENT SYSTEM AND SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.05.2011 FR 1154171**

(43) Date de publication de la demande:
**19.03.2014 Bulletin 2014/12**

(73) Titulaire: **Valeo Equipements Electriques Moteur**
**94046 Créteil Cedex (FR)**

(72) Inventeur: **BENCHETRITE, Daniel**
**F-94000 Creteil (FR)**

(74) Mandataire: **Cardon, Nicolas et al**
**Valeo Systèmes de Contrôle Moteur**
**Immeuble Le Delta**
**14, avenue des Béguines**
**95800 Cergy St Christophe (FR)**

(56) Documents cités:
**US-A1- 2009 115 419    US-A1- 2010 066 377**
**US-B2- 6 515 454**

- **SRDJAN M LUKIC ET AL: "Energy Storage Systems for Automotive Applications", IEEE TRANSACTIONS ON INDUSTRIAL ELECTRONICS, IEEE SERVICE CENTER, PISCATAWAY, NJ, USA, vol. 55, no. 6, 1 juin 2008 (2008-06-01), pages 2258-2267, XP011204038, ISSN: 0278-0046**

**Description**

La présente invention concerne de manière générale l'estimation de l'état de fonctionnement d'une batterie de véhicule automobile pour un système d'arrêt/relance du moteur thermique, cette estimation étant faite à partir de la prise en compte d'une résistance électrique interne de la batterie. L'invention concerne également un capteur de mesure de batterie selon la revendication 8 et un système de gestion de batterie selon la revendication 9 adaptés à la mise en oeuvre du procédé de l'invention selon la revendication 1.

Des considérations d'économie d'énergie et de réduction de la pollution, surtout en milieu urbain, ont conduit les constructeurs automobiles à proposer des véhicules dit de type « micro-hybrid » qui sont équipés d'un système d'arrêt/relance automatique du moteur thermique dit « Stop & Go » ou « Stop/Start » en terminologie anglaise. Deux systèmes de ce type sont actuellement proposés : un système basé sur l'utilisation d'un alterno-démarreur et un système basé sur l'utilisation d'un démarreur dit « renforcé » capable de tenir un nombre très élevé de cycles de démarrage sur la vie du véhicule, comparativement à un démarreur classique.

Dans ces véhicules équipés de systèmes d'arrêt/relance automatique du moteur thermique, un suivi rigoureux de l'état de la batterie du véhicule est nécessaire compte-tenu que celle-ci est beaucoup plus sollicitée que dans un véhicule classique. Des indicateurs d'état SOC, SOH et SOF, respectivement, pour « State of Charge », « State of Health » et « State of Function » en terminologie anglaise, peuvent être utilisés à cette fin. Ces indicateurs SOC, SOH et SOF peuvent être estimés dans un système de gestion de batterie dit BMS pour « Battery Management System » ou dans une unité électronique de commande du véhicule telle que l'unité VMU pour « Vehicle Management Unit ».

Le document US 6 515 454 B2 décrit un procédé de estimation de la capacité d'une batterie en utilisant une modèle de batterie.

L'indicateur d'état de fonctionnement SOF présente un intérêt particulier dans ces véhicules, notamment pour être en mesure d'implanter une stratégie de commande adaptée au système d'arrêt/relance automatique. En effet, dans un tel système, il est souhaitable d'avoir une certaine capacité d'anticipation de manière, par exemple, à éviter une situation dans laquelle l'état de la batterie ne permettrait pas un redémarrage du moteur thermique après que celui a été arrêté par le système d'arrêt/relance automatique.

Dans la mesure où sont connus la résistance interne de la batterie et le courant que celle-ci doit fournir pour assurer le démarrage du moteur thermique, l'anticipation de la tension aux bornes de la batterie lors d'un futur démarrage est un indicateur SOF qui donne satisfaction. Cet indicateur est exprimé par l'égalité suivante :

$$SOF = Ub + (Ipred - Ib).Rb$$

Ub étant la tension de batterie, mesurée au moment de l'estimation de l'indicateur ;
Rb étant la résistance interne de la batterie ;
Ipred étant le courant que doit fournir la batterie pour garantir le démarrage du moteur thermique ; et
Ib étant le courant de batterie mesuré au moment de l'estimation de l'indicateur.

On notera ici, pour toute la description qui suit, qu'un signe positif est affecté à un courant de charge de la batterie et un signe négatif est affecté à un courant de décharge de la batterie.

Le courant de batterie Ipred, de signe négatif, est communiqué par le constructeur automobile pour un moteur thermique donné.

La tension Ub aux bornes de la batterie et le courant de batterie Ib sont mesurés classiquement par un capteur de batterie.

La résistance interne Rb doit également être mesurée. La précision de l'indicateur SOF dépend beaucoup de la qualité de mesure de Rb.

Il est connu dans la technique antérieure de mesurer la résistance interne d'une batterie par un essai de décharge. La résistance interne est alors obtenue par calcul d'un rapport $\Delta U/\Delta I$ entre un delta sur la tension aux bornes de la batterie, $\Delta U$, et un delta sur le courant traversant la batterie $\Delta I$. Selon les méthodes de mesure de résistance interne proposées, l'essai de décharge varie de quelques secondes à quelques minutes. De telles durées peuvent s'avérer prohibitives pour des systèmes d'arrêt/relance automatique qui demandent une estimation fine et en quasi-temps réel de l'indicateur SOF.

Il est souhaitable de proposer une nouvelle solution d'obtention d'un indicateur SOF qui soit bien adaptée pour la majorité des systèmes d'arrêt/relance automatique et qui soit la moins intrusive possible pour ceux-ci.

Selon un premier aspect, la présente invention concerne un procédé d'estimation de l'état de fonctionnement SOF d'une batterie pour un véhicule automobile équipé d'un système d'arrêt/relance automatique du moteur thermique, cette estimation faisant appel à des mesures de courant et tension de la batterie ainsi qu'à un calcul de sa résistance interne.

Conformément à l'invention, l'état de fonctionnement SOF est estimé pendant chaque phase de stop commandée par le système d'arrêt/relance automatique du moteur thermique à partir d'un processus de calcul récursif de type Kalman. De préférence, l'état de fonctionnement SOF est représenté par une estimation de la tension aux bornes de la batterie lors d'une prochaine phase de relance commandée par le système d'arrêt/relance automatique du moteur thermique.

Selon une forme de réalisation particulière de l'invention, l'état de fonctionnement SOF de la batterie est estimé à l'aide de l'égalité récursive suivante :

$$SOF_{ni} = Ub_{ni} + (I_{pred} - Ib_{ni}).Rb_{n-1},$$

sachant que :

SOF$_{ni}$ est l'estimation de l'état de fonctionnement de la batterie à un instant i pendant une phase de stop PS$_n$ ;
Ub$_{ni}$ et Ib$_{ni}$ sont la tension et le courant de batterie mesurés à l'instant i pendant la phase de stop PS$_n$ ;
Rb$_{n-1}$ est la résistance interne calculée pendant une phase PR$_{n-1}$ de démarrage/relance du moteur thermique antérieure à la phase PS$_n$ ; et
I$_{pred}$ est le courant que doit fournir la batterie pour relancer le moteur thermique.

.Les courants Ib$_{ni}$ et I$_{pred}$ sont des courants signés, avec un signe négatif lorsque le courant est fourni par la batterie et un signe positif dans le cas contraire.

Selon une caractéristique particulière, les mesures de courant et tension de la batterie pendant les phase de stop et des phases de démarrage/relance (PR$_n$) commandées par le système d'arrêt/relance automatique sont des mesures échantillonnées effectuées périodiquement avec une première fréquence d'échantillonnage.

Selon une autre caractéristique particulière, les mesures de courant et tension de la batterie effectuées en dehors des phases de stop et des phases de démarrage/relance sont des mesures échantillonnées effectuées périodiquement avec une seconde fréquence d'échantillonnage inférieure à la première fréquence d'échantillonnage. De préférence, les première et seconde fréquences d'échantillonnage sont respectivement de l'ordre de 1 kHz et 5 Hz.

Selon encore une autre caractéristique particulière, la mesure de la résistance interne de la batterie est effectuée pendant une phase de démarrage/relance du moteur thermique et comporte les étapes de :

a) activer une fenêtre temporelle de mesure de la résistance interne de la batterie pendant une durée prédéterminée lorsqu'une décharge de la batterie supérieure à une décharge de niveau prédéterminée est détectée;

b) dans cette fenêtre temporelle, collecter une pluralité d'échantillons de mesure de la tension aux bornes de la batterie et une pluralité d'échantillons de mesure du courant délivré par la batterie et rechercher dans ces pluralités d'échantillons de mesure un couple de mesure tension-courant correspondant, sensiblement à un même instant de mesure, à un échantillon de mesure de tension de valeur minimale et un échantillon de mesure de courant de valeur maximale, ces valeurs minimale et maximale étant considérées en valeur absolue; et

c) calculer la résistance interne de la batterie à partir du couple de mesure tension-courant obtenu à l'étape b) ci-dessus et d'un autre couple de valeurs tension-courant de la batterie mesuré avant le début de la phase de démarrage/relance.

De préférence, la fenêtre temporelle de mesure a une durée de l'ordre de 100 millisecondes.

Selon d'autres aspects, l'invention concerne aussi un capteur de mesure de batterie et un système de gestion de batterie pour véhicule automobile comportant des moyens aptes à la mise en oeuvre du procédé brièvement décrit ci-dessus.

L'invention est maintenant décrite au travers de différents exemples de réalisation, en référence aux dessins ci-annexés. Il est à noter que ces dessins n'ont d'autre but que d'illustrer le texte de la description et ne constituent en aucune sorte une limitation de la portée de l'invention.

La Fig.1 est un bloc-diagramme d'une architecture de véhicule, représentée partiellement, montrant un système de propulsion à moteur thermique équipé d'un système d'arrêt/relance automatique du moteur thermique et une unité d'alimentation à batterie, dans lesquels est intégrée une forme de réalisation de l'invention;

La Fig.2 est un graphique temporel illustrant un processus récursif utilisé pour d'obtention de l'indicateur SOF selon le procédé de l'invention ; et

La Fig.3 montre un exemple de courbes de tension et de courant relatives à la batterie lors d'un démarrage du moteur thermique du véhicule.

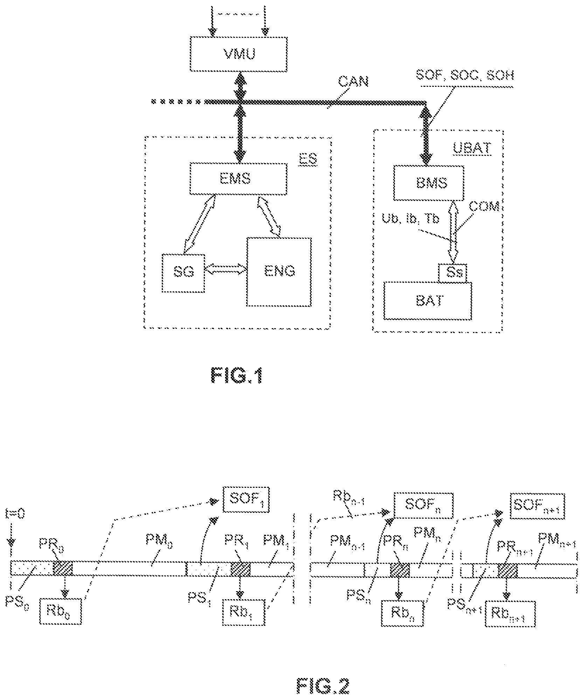

En référence à la Fig.1, il est brièvement décrit ci-après un exemple d'architecture d'un véhicule équipé d'un système d'arrêt/relance automatique du moteur thermique. Ce véhicule comprend un système de propulsion ES à moteur thermique et une unité de batterie d'alimentation UBAT.

Le système de propulsion ES comporte essentiellement un moteur thermique ENG capable d'assurer la traction du véhicule. Le fonctionnement du moteur ENG est contrôlé par un système de gestion de moteur thermique EMS. Le moteur thermique ENG est, dans cette forme de réalisation, équipé d'un alterno-démarreur SG qui assure les fonctions de démarreur du moteur thermique et de génératrice électrique. Dans sa fonction de génératrice électrique, l'alterno-démarreur SG assure l'alimentation en électricité du véhicule et notamment la recharge électrique de l'unité de batterie d'alimentation UBAT. Le fonctionnement de l'alterno-démarreur SG est ici contrôlé par le système EMS.

L'unité de batterie d'alimentation UBAT comporte essentiellement une batterie BAT équipée d'un capteur de mesure de batterie Ss et un système de gestion de batterie BMS.

On notera ici que les systèmes de gestion EMS et BMS sont reliés tous deux à un bus de communication CAN du véhicule et peuvent échanger des informations entre eux ainsi qu'avec un système de gestion de véhicule VMU qui contrôle le fonctionnement général du véhicule. Dans cet exemple de réalisation, les systèmes de gestion VMU, EMS et BMS sont bâtis chacun autour d'une unité électronique de commande dédiée (non représentée).

Dans l'unité de batterie d'alimentation UBAT, le capteur de mesure de batterie Ss mesure la tension Ub aux bornes de la batterie BAT, le courant Ib qui la traverse, ainsi que sa température Tb. Des échantillons de mesure pour Ub, Ib et Tb sont prélevés et numérisés par le capteur Ss qui les transmet ensuite au système de gestion de batterie BMS à travers une liaison de communication COM. Le système BMS traite les mesures de Ub, Ib et Tb reçues en provenance du capteur Ss, à l'aide de modules logiciels résidents, et délivre sur le bus de communication CAN les indicateurs SOC, SOH et SOF décrivant la batterie BAT. Les indicateurs SOC, SOH et SOF sont transmis à travers le bus CAN aux unités électroniques de commande ayant besoin de ces informations pour le fonctionnement des applications embarquées du véhicule.

Bien entendu, l'architecture décrite brièvement ci-dessus n'est qu'un exemple de réalisation parmi de nombreuses configurations dans lesquelles l'invention peut être mise en oeuvre. Selon les applications dans les véhicules, différentes formes de réalisation et implantations des composants fonctionnels sont possibles. Ainsi, par exemple, l'indicateur SOF peut dans certains cas être calculé, non pas dans le système BMS, mais par exemple dans le VMU. Pour d'autres applications, la fonction BMS pourra être hébergée dans l'unité électronique d'un autre système de gestion et ne pas être supportée par une unité électronique dédiée.

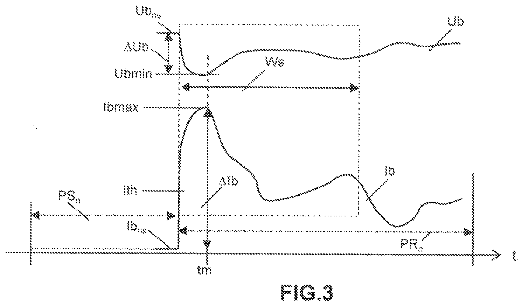

Le procédé de l'invention va maintenant être décrit en détail en référence plus particulièrement aux Figs.2 et 3.

Le procédé d'estimation de l'indicateur SOF selon l'invention fait appel à un algorithme récursif de type Kalman.

Ce processus de calcul récursif, illustré de manière graphique à la Fig.2, se déroule essentiellement pendant les phases de démarrage/relance du moteur thermique, repérées PR, et pendant les phases de stop de celui-ci, repérées PS. Des phases de marche du moteur thermique, repérées PM, sont également représentées à la Fig.2.

La résistance interne Rb de la batterie est calculée lors de chaque phase de démarrage/relance PR. L'indicateur SOF est calculé pendant les phases de stop PS qui suivent une commande d'arrêt du moteur thermique par le système d'arrêt/relance automatique.

La phase $PS_0$ montrée à la Fig.2 est une phase de stationnement du véhicule avec le moteur à l'arrêt. Dans cette forme de réalisation, aucun calcul de SOF n'est effectué pendant cette phase $PS_0$. On notera cependant qu'une valeur de SOF calculée avant le stationnement du véhicule peut avoir été conservée dans un registre mémoire à la disposition du système de gestion VMU ou EMS qui en aurait éventuellement besoin pour sa stratégie de commande.

Une phase de démarrage $PR_0$ succède à la phase $PS_0$ lorsqu'un ordre de démarrage du moteur est initié par le conducteur du véhicule.

Pendant cette phase de démarrage $PR_0$, il est effectué des mesures de courant et tension de la batterie et un premier calcul $Rb_0$ de sa résistance interne. La valeur $Rb_0$ est mémorisée dans un registre du système BMS pour une utilisation ultérieure dans le calcul de l'indicateur SOF.

Après une phase de marche $PM_0$ faisant suite à $PR_0$, une phase de stop $PS_1$ du moteur thermique est commandée par le système d'arrêt/relance automatique. Pendant cette phase de stop $PS_1$, des mesures successives de couples courant-tension de la batterie sont faites par le capteur Ss à une fréquence rapide Fe et, pour chaque couple courant-tension mesuré, il est calculé une valeur $SOF_1$ de l'indicateur SOF. Il est ainsi calculé une suite de valeurs $SOF_{11}$, $SOF_{12}$, ..., $SOF_{1i}$, $SOF_{1(i+1)}$ ... La valeur $SOF_{1i}$ est calculée de la manière suivante :

$$SOF_{1i} = Ub_{1i} + (I_{pred} - Ib_{1i}).Rb_0,$$

sachant que:

$Ub_{1i}$ et $Ib_{1i}$ sont la tension et le courant de batterie mesurés à l'instant i pendant la phase de stop $PS_1$ ;

$Rb_0$ est la résistance interne calculée pendant la phase de stationnement $PS_0$; et

$I_{pred}$ est le courant, de signe négatif, que doit fournir la batterie pour relancer le moteur thermique. $I_{pred}$ est une donnée fournie par le constructeur automobile.

Une nouvelle valeur $Rb_1$ de résistance interne est calculée ensuite pendant la phase de relance $PR_1$ qui suit la phase de stop $PS_1$. $Rb_1$ sera utilisée pour le calcul d'une suite de valeurs $SOF_{21}$, $SOF_{22}$, ..., $SOF_{2i}$, $SOF_{2(i+1)}$ ... pendant la phase de stop suivante $PS_2$ (non représentée) .

De manière générale, pour une phase de stop $Ps_n$, avec n>0, une suite de valeurs $SOF_{n1}$, $SOF_{n2}$, ..., $SOF_{ni}$, $SOF_{n(i+1)}$ ... sera obtenue en application de l'égalité suivante :

$$SOF_{ni} = Ub_{ni} + (I_{pred} - Ib_{ni}).Rb_{n-1},$$

sachant que :

$Ub_{ni}$ et $Ib_{ni}$ sont la tension et le courant de batterie mesurés à l'instant i pendant la phase de stop $Ps_n$ ;

$Rb_{n-1}$ est la résistance interne calculée pendant la phase de stop $PS_{n-1}$ (ou de stationnement si n=1).

Pendant les phases de stop $PS_n$, le système d'arrêt/relance automatique scrute en permanence les valeurs de SOF ($SOF_{n1}$, $SOF_{n2}$, ..., $SOF_{ni}$, $SOF_{n(i+1)}$ ...) qui lui sont transmises par le système BMS. Cette scrutation permet au système d'arrêt/relance automatique d'ordonner une relance du moteur thermique avant une dégradation trop importante du SOF qui interdirait une telle relance. En effet, pendant les phases de stop $PS_n$, la consommation électrique du véhicule est assurée uniquement par la batterie (alternateur à l'arrêt) et le SOF de celle-ci peut se dégrader plus ou moins rapidement selon l'importance de cette consommation.

Le calcul, conformément à l'invention, de la résistance interne Rb pendant une phase de démarrage/relance PR est maintenant décrit ci-après de manière détaillée en référence à la Fig.3.

Pour réaliser le calcul de la résistance interne $Rb_n$, le capteur Ss doit être capable d'effectuer à la fréquence rapide Fe des mesures simultanées de la tension de batterie $Ub_{n1}$, $Ub_{n2}$, ... $Ub_{ni}$, $Ub_{n(i+1)}$... et du courant de batterie $Ib_{n1}$, $Ib_{n2}$, ... $Ib_{ni}$, $Ib_{n(i+1)}$.... Typiquement, une fréquence d'échantillonnage Fe de l'ordre de 1 kHz pourra être utilisée ici pour ces mesures.

On notera cependant que cette fréquence d'échantillonnage rapide Fe pour le fonctionnement du capteur Ss n'est requise que lors des mesures de $Ub_{ni}$ et $Ib_{ni}$ pour le calcul de $Rb_n$ pendant les phases $PR_n$ et du SOF pendant les phases $PS_n$ ($PS_n$ avec n>0). En dehors de ces phases, le capteur Ss pourra échantillonner à fréquence basse (de l'ordre de 5 Hz) pour la fourniture de ses mesures Ub, Ib et Ib au système de gestion de batterie BMS. Dans un mode de réalisation particulier de l'invention, le capteur Ss pourra fonctionner à fréquence basse lorsque le courant Ib est positif et charge la batterie BAT (c'est-à-dire, lorsque la batterie est rechargée par l'alternateur du véhicule), le fonctionnement à fréquence rapide Fe intervenant dès lors que le courant Ib devient négatif et décharge la batterie BAT.

En référence à la Fig.3, lorsque le système BMS détecte, après une phase de repos (stationnement) ou de stop $PS_n$, un courant important Ib fourni par la batterie BAT, une fenêtre Ws pour une mesure à fréquence rapide Fe est activée. Cette fenêtre Ws aura une durée typiquement de l'ordre de 100 ms. La fenêtre Ws est activée ici lorsque le courant de décharge Ib devient supérieur, en valeur absolue, à un seuil prédéterminé Ith. Selon une variante, la condition d'une pente du courant Ib supérieure à une valeur de seuil prédéterminée sera également nécessaire pour l'activation de la fenêtre de mesure Ws. Selon encore une autre variante, l'activation de la fenêtre Ws sera commandée à partir d'une détection faite sur la tension Ub et non sur le courant Ib.

Pendant toute la durée de la fenêtre Ws, le courant Ib et la tension Ub sont mesurés par échantillonnage à la fréquence rapide Fe. Un processus de traitement hébergé dans le système BMS traite un flux de données numériques transmis par le capteur Ss et en extrait des données de mesure de tension $Ub_{n1}$, $Ub_{n2}$, ... $Ub_{ni}$, $Ub_{n(i+1)}$... et de courant $Ib_{n1}$, $Ib_{n2}$, ... $Ib_{ni}$, $Ib_{n(i+1)}$.... Le processus de traitement effectue une recherche dans ces données de mesure extraites de manière à identifier un couple tension-courant (Ubmin, Ibmax) à un temps tm de la fenêtre de mesure Ws. Ubmin est la valeur de la tension Ub correspondant à une chute de tension maximale de celle-ci dans la fenêtre Ws. A Ubmin est associé le courant Ibmax qui correspond à une intensité maximale du courant de décharge Ib dans la fenêtre Ws.

Une fois déterminé le couple (Ubmin, Ibmax), la résistance interne $Rb_n$ est donnée par la formule ci-dessous:

$$Rb_n = \Delta Ub/\Delta Ib = \text{Valeur Absolue}[(Ub_{ns}-Ubmin)/(Ibmax-Ib_{ns})],$$

avec $Ub_{ns}$ et $Ib_{ns}$ qui sont les dernières valeurs mesurées des tension et courant, Ub et Ib, de la batterie pendant la phase $PS_n$, donc peu de temps avant le déclenchement de la fenêtre de mesure Ws.

Bien entendu, différentes variantes de réalisation de l'invention sont à la portée de l'homme du métier instruit par les enseignements qui lui sont apportés ici. Ainsi, par exemple, dans certaines applications, le traitement de calcul de la résistance interne de la batterie pourra être effectué par des moyens adaptés prévus dans le capteur Ss, soulageant ainsi le système BMS d'une charge de calcul. De plus, dans un tel cas, la liaison de communication COM pourra avoir un débit plus faible du fait qu'il deviendra alors inutile de transmettre au système BMS les mesures de Ub et Ib faites à la fréquence rapide Fe dans la fenêtre Ws.

**Revendications**

1. Procédé d'estimation de l'état de fonctionnement (SOF) d'une batterie (BAT) pour un véhicule automobile équipé d'un système d'arrêt/relance automatique du moteur thermique, ladite estimation faisant appel à des mesures de courant (Ib) et tension (Ub) de la batterie ainsi qu'à un calcul de sa résistance interne (Rb), **caractérisé en ce que** ledit état de fonctionnement (SOF) est estimé pendant chaque phase de stop ($PS_n$) commandée par le système d'arrêt/relance automatique du moteur thermique à partir d'un processus de calcul récursif de type Kalman, ledit l'état de fonctionnement (SOF) étant représenté par une estimation de la tension aux bornes de la batterie lors d'une prochaine phase de relance ($PR_n$) commandée par le système d'arrêt/relance automatique du moteur thermique (ENG).

2. Procédé selon la revendication 1, **caractérisé en ce que** l'état de fonctionnement (SOF) de la batterie est estimé à l'aide de l'égalité récursive suivante :

$$SOF_{ni}= Ub_{ni} + (I_{pred} - Ib_{ni}).Rb_{n-1},$$

sachant que :

$SOF_{ni}$ est l'estimation de l'état de fonctionnement à un instant i pendant une phase de stop $PS_n$ ;
$Ub_{ni}$ et $Ib_{ni}$ sont la tension et le courant de batterie mesurés à l'instant i pendant la phase de stop $PS_n$;
$Rb_{n-1}$ est la résistance interne calculée pendant une phase $PR_{n-1}$ de démarrage/relance du moteur thermique antérieure à la phase $PS_n$ ; et
$I_{pred}$ est le courant que doit fournir la batterie pour relancer le moteur thermique ;
lesdits courants $Ib_{ni}$ et $I_{pred}$ étant des courants signés, avec un signe négatif lorsque le courant est fourni par la batterie et un signe positif dans le cas contraire.

3. Procédé selon l'une quelconque des revendications 1 ou 2, **caractérisé en ce que** les mesures de courant (Ib) et tension (Ub) de la batterie pendant les phase de stop ($PS_n$) et des phases de démarrage/relance ($PR_n$) commandées par le système d'arrêt/relance automatique sont des mesures échantillonnées effectuées périodiquement avec une première fréquence d'échantillonnage.

4. Procédé selon la revendication 3, **caractérisé en ce que** les mesures de courant (Ib) et tension (Ub) de la batterie effectuées en dehors desdites phases de stop ($PS_n$) et des phases de démarrage/relance ($PR_n$) sont des mesures échantillonnées effectuées périodiquement avec une seconde fréquence d'échantillonnage inférieure à ladite première fréquence d'échantillonnage.

5. Procédé selon la revendication 3 ou 4, **caractérisé en ce que** lesdites première et seconde fréquences d'échantillonnage sont respectivement de l'ordre de 1 kHz et 5 Hz.

6. Procédé selon l'une quelconque des revendications 1 à 5, **caractérisé en ce que** ladite mesure de la résistance interne (Rb) de la batterie est effectuée pendant une phase de démarrage/relance ($PR_n$) du moteur thermique et comporte les étapes de :

a) activer une fenêtre temporelle (Ws) de mesure de la résistance interne (Rb) de la batterie pendant une durée prédéterminée (100 ms) lorsqu'une décharge (Ib) de la batterie supérieure à une décharge de niveau prédéterminée (Ith) est détectée;

b) dans ladite fenêtre temporelle (Ws), collecter une pluralité d'échantillons de mesure de la tension (Ub) aux bornes de la batterie et une pluralité d'échantillons de mesure du courant (Ib) délivré par la batterie et rechercher dans ces pluralités d'échantillons de mesure un couple de mesure tension-courant (Ubmin, Ibmax) correspondant, sensiblement à un même instant de mesure (tm), à un échantillon de mesure de tension de valeur minimale et un échantillon de mesure de courant de valeur maximale, ces valeurs minimale et maximale étant considérées en valeur absolue; et

c) calculer la résistance interne (Rb) de la batterie à partir du couple de mesure tension-courant (Ubmin, Ibmax) obtenu à l'étape b) ci-dessus et d'un autre couple de valeurs tension-courant (Ub$_{ns}$, Ib$_{ns}$) de la batterie mesuré avant le début de ladite phase de démarrage/relance (PR$_n$).

7. Procédé selon la revendication 6, **caractérisé en ce que** ladite fenêtre temporelle (Ws) a une durée de l'ordre de 100 millisecondes.

8. Capteur de mesure de batterie pour véhicule automobile, **caractérisé en ce qu'**il comprend des moyens adaptés à la mise en oeuvre du procédé selon l'une quelconque des revendications 1 à 7.

9. Système de gestion de batterie pour véhicule automobile, **caractérisé en ce qu'**il comprend des moyens adaptés à la mise en oeuvre du procédé selon l'une quelconque des revendications 1 à 7.

**Patentansprüche**

1. Verfahren zum Abschätzen des Betriebszustandes (SOF) einer Batterie (BAT) für ein Kraftfahrzeug, das mit einem automatischen Start/Stopp-System der Brennkraftmaschine ausgestattet ist, wobei die Abschätzung Messungen des Stroms (Ib) und der Spannung (Ub) der Batterie sowie eine Berechnung ihres internen Widerstandes (Rb) nutzt, **dadurch gekennzeichnet, dass** der Betriebszustand (SOF) während jeder Stoppphase (PS$_n$), die durch das automatische Start/Stopp-System der Brennkraftmaschine gesteuert wird, anhand eines Prozesses einer rekursiven Berechnung vom Kalman-Typ abgeschätzt wird, wobei der Betriebszustand (SOF) durch eine Abschätzung der Spannung an den Anschlüssen der Batterie in einer nächsten Neustartphase (PR$_n$) dargestellt wird, die durch das automatische Start/Stopp-System der Brennkraftmaschine (ENG) gesteuert wird.

2. Verfahren nach Anspruch 1, **dadurch gekennzeichnet, dass** der Betriebszustand (SOF) der Batterie mit Hilfe der folgenden rekursiven Gleichheit abgeschätzt wird:

$$SOF_{ni} = Ub_{ni} + (I_{pred} - Ib_{ni}).Rb_{n-1},$$

in Kenntnis davon, dass:

SOF$_{ni}$ die Abschätzung des Betriebszustandes zu einem Zeitpunkt i während einer Stoppphase PS$_n$ ist;

Ub$_{ni}$ und Ib$_{ni}$ die Spannung und der Strom der Batterie sind, die zum Zeitpunkt i während der Stoppphase PS$_n$ gemessen werden;

Rb$_{n-1}$ der interne Widerstand ist, der während einer Phase PR$_{n-1}$ des Starts/Neustarts der Brennkraftmaschine vor der Phase PS$_n$ berechnet wird; und

I$_{pred}$ der Strom ist, den die Batterie liefern muss, um die Brennkraftmaschine erneut zu starten;

wobei die Ströme Ib$_{ni}$ und I$_{pred}$ Ströme mit Vorzeichen mit einem negativen Vorzeichen, wenn der Strom von der Batterie geliefert wird, und einem positiven Vorzeichen im gegenteiligen Fall sind.

3. Verfahren nach einem der Ansprüche 1 oder 2, **dadurch gekennzeichnet, dass** die Messungen des Stroms (Ib) und der Spannung (Ub) der Batterie während der Stoppphase (PS$_n$) und den Start/Neustart-Phasen (PR$_n$), die durch das automatische Start/Stopp-System gesteuert werden, Abtastmessungen sind, die periodisch mit einer ersten Abtastfrequenz durchgeführt werden.

4. Verfahren nach Anspruch 3, **dadurch gekennzeichnet, dass** die Messungen des Stroms (Ib) und der Spannung (Ub) der Batterie, die außerhalb der Stoppphasen ($PS_n$) und der Start/Neustart-Phasen ($PR_n$) durchgeführt werden, Abtastmessungen sind, die periodisch mit einer zweiten Abtastfrequenz durchgeführt werden, die geringer ist als die erste Abtastfrequenz.

5. Verfahren nach Anspruch 3 oder 4, **dadurch gekennzeichnet, dass** die erste und die zweite Abtastfrequenz in der Größenordnung von 1 kHz bzw. 5 Hz liegen.

6. Verfahren nach einem der Ansprüche 1 bis 5, **dadurch gekennzeichnet, dass** die Messung des internen Widerstandes (Rb) der Batterie während einer Start/Neustart-Phase ($PR_n$) der Brennkraftmaschine durchgeführt wird und die folgenden Schritte umfasst:

a) Aktivieren eines Zeitfensters (Ws) zur Messung des internen Widerstandes (Rb) der Batterie während einer vorbestimmten Dauer (100 ms), wenn eine Entladung (Ib) der Batterie oberhalb einer Entladung eines vorbestimmten Niveaus (Ith) detektiert wird;
b) im Zeitfenster (Ws) Sammeln von mehreren Abtastwerten der Messung der Spannung (Ub) an den Anschlüssen der Batterie und mehreren Abtastwerten der Messung des Stroms (Ib), der von der Batterie geliefert wird, und Suchen eines Paars einer Spannungs-Strom-Messung (Ubmin, Ibmax) in diesen mehreren Messabtastwerten, das im Wesentlichen zu einem gleichen Messzeitpunkt (tm) einem Abtastwert der Messung der Spannung mit einem minimalen Wert und einem Abtastwert der Messung des Stroms mit einem maximalen Wert entspricht, wobei diese minimalen und maximalen Werte als Absolutwert betrachtet werden; und
c) Berechnen des internen Widerstandes (Rb) der Batterie anhand des Paars der Spannungs-Strom-Messung (Ubmin, Ibmax), das im vorstehenden Schritt b) erhalten wird, und eines anderen Paars von Spannungs-Strom-Werten ($Ub_{ns}$, $Ib_{ns}$) der Batterie, das vor dem Beginn der Start/Neustart-Phase ($PR_n$) gemessen wird.

7. Verfahren nach Anspruch 6, **dadurch gekennzeichnet, dass** das Zeitfenster (Ws) eine Dauer in der Größenordnung von 100 Millisekunden hat.

8. Messsensor einer Batterie für ein Kraftfahrzeug, **dadurch gekennzeichnet, dass** er Mittel umfasst, die für die Ausführung des Verfahrens nach einem der Ansprüche 1 bis 7 ausgelegt sind.

9. Steuersystem einer Batterie für ein Kraftfahrzeug, **dadurch gekennzeichnet, dass** es Mittel umfasst, die für die Ausführung des Verfahrens nach einem der Ansprüche 1 bis 7 ausgelegt sind.

## Claims

1. Method for estimating the operating state (SOF) of a battery (BAT) for a motor vehicle fitted with an automatic start-stop system for the combustion engine, said estimate making use of current (Ib) and voltage (Ub) measurements of the battery and of a calculation of its internal resistance (Rb), **characterized in that** said operating state (SOF) is estimated in each stop phase ($PS_n$) controlled by the automatic start-stop system for the combustion engine on the basis of a Kalman-type recursive calculation process, said operating state (SOF) being represented by an estimate of the voltage across the terminals of the battery in a subsequent start phase ($PR_n$) controlled by the automatic start-stop system for the combustion engine (ENG).

2. Method according to Claim 1, **characterized in that** the operating state (SOF) of the battery is estimated using the following recursive equality:

$$SOF_{ni} = Ub_{ni} + (I_{pred} - Ib_{ni}).Rb_{n-1},$$

given that:

$SOF_{ni}$ is the estimate of the operating state at a time i in a stop phase $PS_n$;
$Ub_{ni}$ and $Ib_{ni}$ are the battery voltage and current measured at the time i in the stop phase $PS_n$;
$Rb_{n-1}$ is the internal resistance calculated in a start/restart phase $PR_{n-1}$ of the combustion engine prior to the phase $PS_n$; and

$I_{pred}$ is the current that must be supplied by the battery in order to restart the combustion engine;

said currents $Ib_{ni}$ and $I_{pred}$ being signed currents, with a negative sign when the current is delivered by the battery and a positive sign in the opposite case.

3. Method according to either of Claims 1 and 2, **characterized in that** the current (Ib) and voltage (Ub) measurements of the battery in the stop phases ($PS_n$) and start/restart phases ($PR_n$) controlled by the automatic start-stop system are sampled measurements taken periodically with a first sampling frequency.

4. Method according to Claim 3, **characterized in that** the current (Ib) and voltage (Ub) measurements of the battery taken outside of said stop phases ($PS_n$) and start/restart phases ($PR_n$) are sampled measurements taken periodically with a second sampling frequency lower than said first sampling frequency.

5. Method according to Claim 3 or 4, **characterized in that** said first and second sampling frequencies are of the order of 1 kHz and 5 Hz, respectively.

6. Method according to any one of Claims 1 to 5, **characterized in that** said measurement of the internal resistance (Rb) of the battery is taken in a start/restart phase ($PR_n$) of the combustion engine and includes the steps of:

a) activating a time window (Ws) for measuring the internal resistance (Rb) of the battery over a predetermined duration (100 ms) when a discharge (Ib) of the battery that is higher than a predetermined discharge level (Ith) is detected;

b) in said time window (Ws), collecting a plurality of measurement samples of the voltage (Ub) across the terminals of the battery and a plurality of measurement samples of the current (Ib) delivered by the battery and searching through these pluralities of measurement samples for a voltage-current measurement pair (Ubmin, Ibmax) corresponding, substantially at one and the same measurement time (tm), to a minimum value voltage measurement sample and to a maximum value current measurement sample, these minimum and maximum values being considered in terms of absolute value; and

c) calculating the internal resistance (Rb) of the battery on the basis of the voltage-current measurement pair (Ubmin, Ibmax) obtained in step b) above and of another pair of voltage-current values ($Ub_{ns}$, $Ib_{ns}$) of the battery measured before the start of said start/restart phase ($PR_n$).

7. Method according to Claim 6, **characterized in that** the duration of said time window (Ws) is of the order of 100 milliseconds.

8. Battery measurement sensor for a motor vehicle, **characterized in that** it comprises means suitable for implementing the method according to any one of Claims 1 to 7.

9. Battery management system for a motor vehicle, **characterized in that** it comprises means suitable for implementing the method according to any one of Claims 1 to 7.

FIG.1

FIG.2

FIG.3

## RÉFÉRENCES CITÉES DANS LA DESCRIPTION

**Documents brevets cités dans la description**

- US 6515454 B2